# EUROPEAN PATENT APPLICATION

(11) **EP 4 383 342 A2**
(43) Date of publication of application: **12.06.2024**
(21) Application number: 23213815.6
(22) Date of filing: 01.12.2023
(51) Int. Cl.: H01L 29/08, H10B 41/10, H10B 41/27, H10B 41/40, H10B 43/10, H10B 43/27, H10B 43/40, H01L 21/8234

(54) **SEMICONDUCTOR DEVICE AND ELECTRONIC SYSTEM INCLUDING THE SAME**

(30) Priority: 07.12.2022 KR 20220170047
(71) Applicant: Samsung Electronics Co., Ltd., Suwon-si, Gyeonggi-do 16677 (KR)
(72) Inventor: YUN, Kangoh, 16677 Suwon-si (KR); LEE, Sohyun, 16677 Suwon-si (KR); LEE, Dongjin, 16677 Suwon-si (KR); LIM, Junhee, 16677 Suwon-si (KR)
(74) Representative: Marks & Clerk LLP

(57) **Abstract**

A semiconductor device includes a substrate including an active region including a central active region extending in a first direction and first to fourth extended active regions extending from an edge of the central active region in a second direction perpendicular to the first direction, and a device isolation layer defining the active region; and first to fourth gate structures on the active region and spaced apart from one another, wherein the central active region, the first to fourth extended active regions, and the first to fourth gate structures constitute first to fourth pass transistors, the first to fourth pass transistors share one drain region on the central active region, and the active region has an H shape in a plan view.

## Description

### 1. Field

Embodiments relate to a semiconductor device and an electronic system including the same.

### 2. Description of the Related Art

A semiconductor device capable of storing high-capacity data may be used for an electronic system requiring data storage. Accordingly, a method of increasing data storage capacity of the semiconductor device has been considered. For example, as a methods of increasing the data storage capacity of the semiconductor device, a semiconductor device including a vertical memory device with three-dimensionally arranged memory cells instead of two-dimensionally arranged memory cells has been considered.

### SUMMARY

The embodiments may be realized by providing a semiconductor device including a substrate including an active region including a central active region extending in a first direction, a first extended active region extending from a first edge of the central active region in a second direction perpendicular to the first direction, a second extended active region extending from a second edge of the central active region in the second direction, a third extended active region extending from a third edge of the central active region in the second direction, and a fourth extended active region extending from a fourth edge of the central active region in the second direction, and a device isolation layer defining the active region; and a first gate structure, a second gate structure, a third gate structure, and a fourth gate structure on the active region and spaced apart from one another, wherein the central active region, the first extended active region, and the first gate structure constitute a first pass transistor, the central active region, the second extended active region, and the second gate structure constitute a second pass transistor, the central active region, the third extended active region, and the third gate structure constitute a third pass transistor, and the central active region, the fourth extended active region, and the fourth gate structure constitute a fourth pass transistor, the first to fourth pass transistors share one drain region on the central active region, and the active region has an H shape in a plan view.

The embodiments may be realized by providing a semiconductor device including a peripheral circuit structure; and a cell array structure overlapping the peripheral circuit structure in a vertical direction and including a first memory cell block, a second memory cell block, a third memory cell block, and a fourth memory cell block, wherein the peripheral circuit structure includes a substrate including an active region including a central active region extending in a first direction, a first extended active region extending from a first edge of the central active region in a second direction perpendicular to the first direction, a second extended active region extending from a second edge of the central active region in the second direction, a third extended active region extending from a third edge of the central active region in the second direction, and a fourth extended active region extending from a fourth edge of the central active region in the second direction, and a device isolation layer defining the active region; and a first gate structure, a second gate structure, a third gate structure, and a fourth gate structure on the active region and spaced apart from one another, the central active region, the first extended active region, and the first gate structure constitute a first pass transistor, the central active region, the second extended active region, and the second gate structure constitute a second pass transistor, the central active region, the third extended active region, and the third gate structure constitute a third pass transistor, and the central active region, the fourth extended active region, and the fourth gate structure constitute a fourth pass transistor, the first to fourth pass transistors share one drain region on the central active region, and the active region has an H shape in a plan view.

The embodiments may be realized by providing an electronic system including a main substrate; a semiconductor device on the main substrate; and a controller electrically connected to the semiconductor device on the main substrate, wherein the semiconductor device includes a substrate including an active region including a central active region extending in a first direction, a first extended active region extending from a first edge of the central active region in a second direction perpendicular to the first direction, a second extended active region extending from a second edge of the central active region in the second direction, a third extended active region extending from a third edge of the central active region in the second direction, and a fourth extended active region extending from a fourth edge of the central active region in the second direction, and a device isolation layer defining the active region; and a first gate structure, a second gate structure, a third gate structure, and a fourth gate structure on the active region and spaced apart from one another, wherein the central active region, the first extended active region, and the first gate structure constitute a first pass transistor, the central active region, the second extended active region, and the second gate structure constitute a second pass transistor, the central active region, the third extended active region, and the third gate structure constitute a third pass transistor, and the central active region, the fourth extended active region, and the fourth gate structure constitute a fourth pass transistor, the first to fourth pass transistors share one drain region on the central active region, and the active region has an H shape in a plan view.

At least some of the above and other features of the invention are set out in the claims.

### BRIEF DESCRIPTION OF THE DRAWINGS

Features will be apparent to those of skill in the art by describing in detail embodiments with reference to the attached drawings in which:
FIG. 1 is a block diagram of a semiconductor device according to an embodiment;
FIG. 2 is an equivalent circuit diagram of a memory cell array of a semiconductor device according to an embodiment;
FIG. 3 is a schematic perspective view of a semiconductor device according to an embodiment;
FIG. 4 is a layout diagram illustrating a semiconductor device according to an embodiment;
FIG. 5A is a cross-sectional view taken along the line A-A' of FIG. 4;
FIG. 5B is a cross-sectional view taken along the line B-B' of FIG. 4;
FIGS. 6A and 6B are layout diagrams illustrating semiconductor devices according to embodiments;
FIGS. 7A to 7C are layout diagrams illustrating semiconductor devices according to embodiments;
FIGS. 8A and 8B are cross-sectional views illustrating semiconductor devices according to embodiments;
FIG. 9 is a diagram schematically illustrating an electronic system including a semiconductor device according to an embodiment;
FIG. 10 is a perspective view schematically illustrating an electronic system including a semiconductor device according to an embodiment; and
FIG. 11 is a cross-sectional view schematically illustrating a semiconductor package according to an embodiment.

### DETAILED DESCRIPTION

Hereinafter, embodiments will be described in detail with reference to the accompanying drawings. Like reference numerals refer to like elements, and their repetitive descriptions may be omitted.

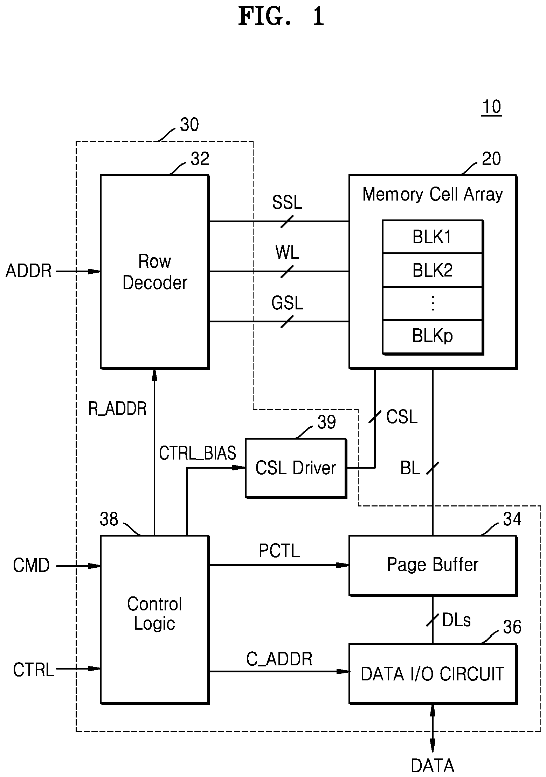

FIG. 1 is a block diagram of a semiconductor device 10 according to an embodiment.

Referring to FIG. 1, the semiconductor device 10 may include a memory cell array 20 and a peripheral circuit 30. The memory cell array 20 includes a plurality of memory cell blocks BLK1, BLK2, ..., and BLKp. Each of the plurality of memory cell blocks BLK1, BLK2, ..., and BLKp may include a plurality of memory cells. The plurality of memory cell blocks BLK1, BLK2, ..., and BLKp may be connected to the peripheral circuit 30 through a bit line BL, a word line WL, a string selection line SSL, and a ground selection line GSL.

The peripheral circuit 30 may include a row decoder 32, a page buffer 34, a data input/output circuit 36, a control logic 38, and a common source line driver 39. The peripheral circuit 30 may further include various circuits, such as a voltage generation circuit generating various voltages required for an operation of the semiconductor device 10, an error correction circuit for correcting errors in data read from the memory cell array 20, and an input/output interface.

The memory cell array 20 may be connected to the row decoder 32 through the word line WL, the string selection line SSL, and the ground selection line GSL, and may be connected to the page buffer 34 through the bit line BL. In the memory cell array 20, the plurality of memory cells included in each of the plurality of memory cell blocks BLK1, BLK2, ..., and BLKp may be flash memory cells, respectively. The memory cell array 20 may include a three-dimensional memory cell array. The three-dimensional memory cell array may include a plurality of NAND strings, and each of the plurality of NAND strings may include a plurality of memory cells respectively connected to a plurality of vertically stacked word lines WL.

The peripheral circuit 30 may receive an address ADDR, a command CMD, and a control signal CTRL from the outside of the semiconductor device 10, and may transmit and receive data DATA to and from a device outside the semiconductor device 10.

The row decoder 32 may select at least one of the plurality of memory cell blocks BLK1, BLK2, ..., and BLKp in response to the address ADDR from the outside, and may select a word line WL, a string selection line SSL, and a ground selection line GSL of the selected memory cell block. The row decoder 32 may transmit a voltage for performing a memory operation to the word line WL of the selected memory cell block.

The page buffer 34 may be connected to the memory cell array 20 through the bit line BL. The page buffer 34 may operate as a write driver during a program operation to apply a voltage in accordance with the data DATA to be stored in the memory cell array 20 to the bit line BL and may operate as a sense amplifier during a read operation to detect the data DATA stored in the memory cell array 20. The page buffer 34 may operate in accordance with a control signal PCTL provided from the control logic 38.

The data input/output circuit 36 may be connected to the page buffer 34 through a plurality of data lines DLs. The data input/output circuit 36 may receive the data DATA from a memory controller during the program operation and may provide program data DATA to the page buffer 34 based on a column address C_ADDR provided from the control logic 38. The data input/output circuit 36 may provide read data DATA stored in the page buffer 34 to the memory controller based on the column address C_ADDR provided from the control logic 38 during the read operation.

The data input/output circuit 36 may transmit an input address or command to the control logic 38 or the row decoder 32. The peripheral circuit 30 may further include an electrostatic discharge (ESD) circuit and a pull-up/pull-down driver.

The control logic 38 may receive the command CMD and the control signal CTRL from the memory controller. The control logic 38 may provide a row address R_ADDR to the row decoder 32 and may provide the column address C_ADDR to the data input/output circuit 36. The control logic 38 may generate various internal control signals used by the semiconductor device 10 in response to the control signal CTRL. In an implementation, the control logic 38 may adjust a voltage level provided to the word line WL and the bit line BL when a memory operation, such as a program operation or an erase operation, is performed.

The common source line driver 39 may be connected to the memory cell array 20 through a common source line CSL. The common source line driver 39 may apply a common source voltage (e.g., a power supply voltage) or a ground voltage to the common source line CSL based on a control signal CTRL_BIAS of the control logic 38.

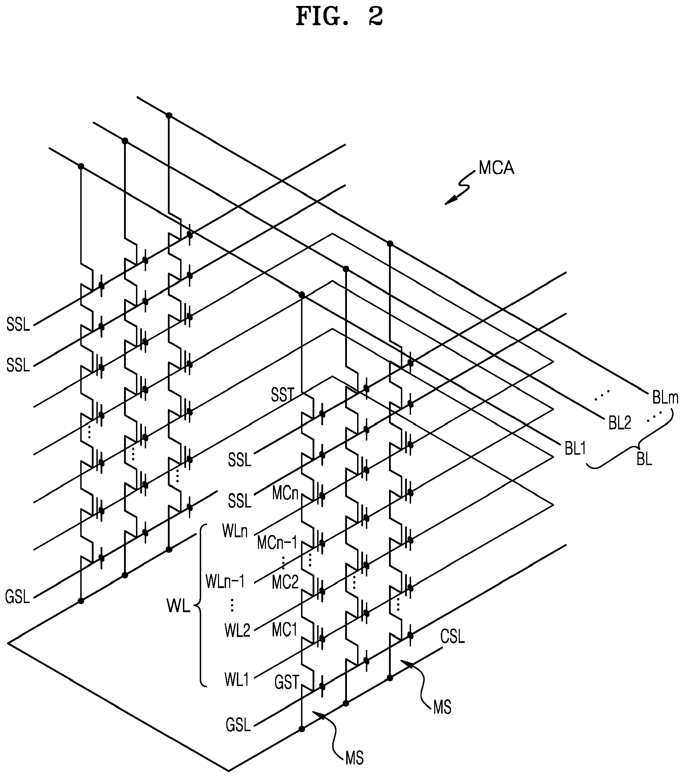

FIG. 2 is an equivalent circuit diagram of a memory cell array MCA of a semiconductor device 10 according to an embodiment.

Referring to FIG. 2, the memory cell array MCA may include a plurality of memory cell strings MS. The memory cell array MCA may include a plurality of bit lines BL: BL1, BL2, ..., and BLm, a plurality of word lines WL: WL1, WL2, ..., WLn-1 and WLn, at least one string selection line SSL, at least one ground selection line GSL, and a common source line CSL. The plurality of memory cell strings MS may be formed between the plurality of bit lines BL: BL1, BL2, ..., and BLm and the common source line CSL. In an implementation, as illustrated in FIG. 2, each of the plurality of memory cell strings MS may include two string selection lines SSL. In an implementation, each of the plurality of memory cell strings MS may include one string selection line SSL.

Each of the plurality of memory cell strings MS may include a string selection transistor SST, a ground selection transistor GST, and a plurality of memory cell transistors MC1, MC2, ..., MCn-1 and MCn. Drain regions of the plurality of string selection transistors SST may be connected to the plurality of bit lines BL: BL1, BL2, ..., and BLm, respectively, and source regions of the plurality of ground selection transistors GST may be commonly connected to the common source line CSL.

The plurality of string selection transistors SST may be connected to the plurality of string selection lines SSL, and the plurality of ground selection transistors GST may be connected to the ground selection line GSL. The plurality of memory cell transistors MC1, MC2, ..., MCn-1 and MCn may be connected to the plurality of word lines WL: WL1, WL2, ..., WLn-1 and WLn, respectively.

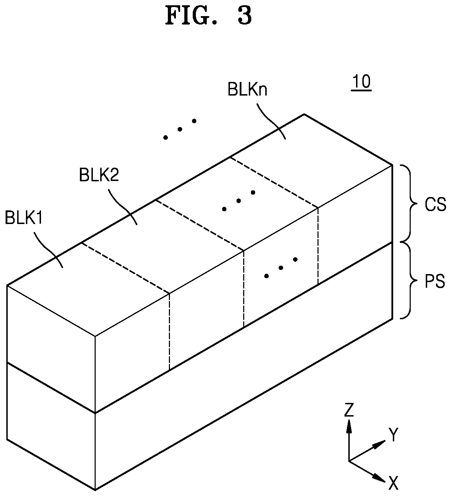

FIG. 3 is a schematic perspective view of a semiconductor device 10 according to an embodiment.

Referring to FIG. 3, the semiconductor device 10 includes a memory cell array structure CS and a peripheral circuit structure PS overlapping each other in a vertical direction.

The memory cell array structure CS may include the memory cell array 20 described with reference to FIG. 1. The peripheral circuit structure PS may include the peripheral circuit 30 described with reference to FIG. 1.

The memory cell array structure CS may include a plurality of tiles. Each of the plurality of tiles may include a plurality of memory cell blocks BLK1, BLK2, ..., and BLKn. Each of the plurality of memory cell blocks BLK1, BLK2, ..., and BLKn may include three-dimensionally arranged memory cells.

In an implementation, two tiles may constitute one mat. In an implementation, the memory cell array 20 described with reference to FIG. 1 may include a plurality of mats.

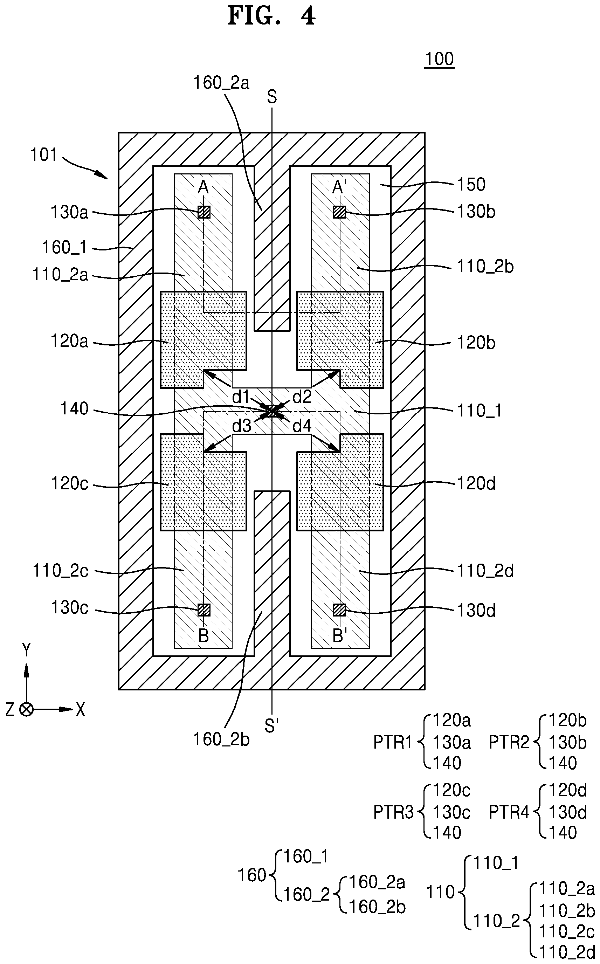

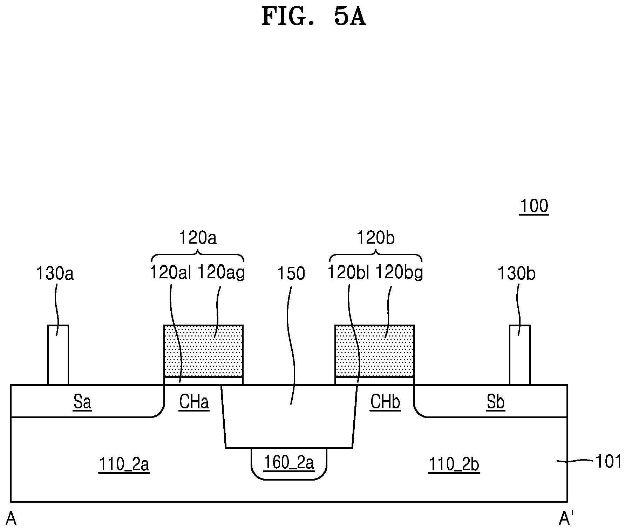

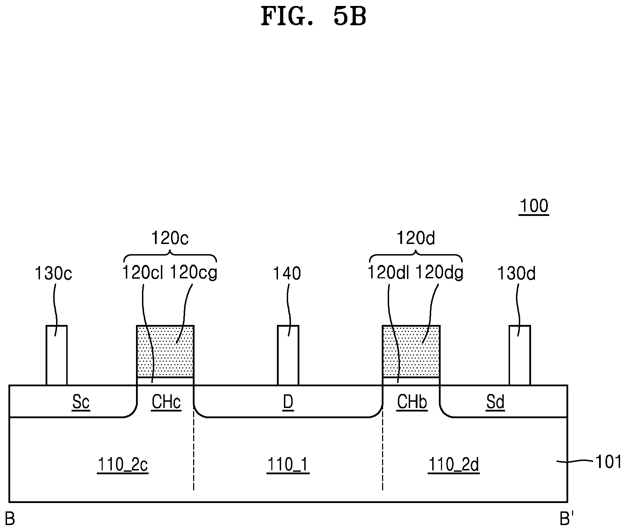

FIG. 4 is a layout diagram illustrating a semiconductor device 100 according to an embodiment. FIG. 5A is a cross-sectional view taken along the line A-A' of FIG. 4. FIG. 5B is a cross-sectional view taken along the line B-B' of FIG. 4.

Referring to FIGS. 4, 5A, and 5B, the semiconductor device 100 includes a substrate 101 and first to fourth gate structures 120a, 120b, 120c, and 120d. The semiconductor device 100 may be in the peripheral circuit structure PS described with reference to FIG. 3.

The substrate 101 may include a semiconductor substrate. In an implementation, the substrate 101 may include silicon (Si), germanium (Ge), or SiGe. An active region 110 is defined on the substrate 101 by a device isolation layer 150. First, second, third, and fourth pass transistors PTR1, PTR2, PTR3, and PTR4 are configured on the active region 110. As used herein, the term "or" is not an exclusive term, e.g., "A or B" would include A, B, or A and B. As used herein, the terms "first," "second," and the like are merely for identification and differentiation, and are not intended to imply or require sequential inclusion (e.g., a third element and a fourth element may be described without implying or requiring the presence of a first element or second element).

The active region 110 includes a central active region 110_1 and first, second, third, and fourth extended active regions 110_2a, 110_2b, 110_2c, and 110_2d. In an implementation, the central active region 110_1 and the first, second, third, and fourth extended active regions 110_2a, 110_2b, 110_2c, and 110_2d (e.g., the active region 110) have an H shape on an X-Y plane (e.g., in a plan view).

The central active region 110_1 extends (e.g., lengthwise) in a first direction (an X direction). The central active region 110_1 may have a rectangular shape on the X-Y plane.

A drain region D may be in or on an upper portion of the central active region 110_1. The drain region D may be doped with a first impurity. The first impurity may include, e.g., an n-type impurity, such as phosphorus (P). The drain region D may be connected to a drain contact 140. The drain contact 140 may receive an operating voltage from a voltage generating circuit included in the peripheral circuit 30 (refer to FIG. 1) and may transmit the operating voltage to a word line WL (refer to FIG. 1), a string selection line SSL (refer to FIG. 1), and a ground selection line GSL of a selected memory cell block. The operating voltage may include, e.g., a program voltage V_{pgm}. In an implementation, the drain contact 140 may be on the X-Y plane in an oblique direction with the first to fourth gate structures 120a, 120b, 120c, and 120d. In an implementation, distances d1, d2, d3, and d4 between the drain contact 140 and the first to fourth gate structures 120a, 120b, 120c, and 120d may be equal to one another. The drain contact 140 may be in the oblique direction with the first to fourth gate structures 120a, 120b, 120c, and 120d, and areas of the first to fourth pass transistors PTR1, PTR2, PTR3, and PTR4 may be reduced while maintaining the distances d1, d2, d3, and d4 between the drain contact 140 and the first to fourth gate structures 120a, 120b, 120c, and 120d. In an implementation, break-down of gate dielectric layers 120al, 120bl, 120cl, and 120dl may be prevented from occurring due to an electric field that may be generated when the distances d1, d2, d3, and d4 between the drain contact 140 and the first to fourth gate structures 120a, 120b, 120c, and 120d are reduced, and the areas of the first to fourth pass transistors PTR1, PTR2, PTR3, and PTR4 may be reduced.

The first, second, third, and fourth extended active regions 110_2a, 110_2b, 110_2c, and 110_2d extend (e.g., lengthwise) from the central active region 110_1 in a second direction (a Y direction) perpendicular to the first direction. In an implementation, the first extended active region 110_2a extends from one edge of the central active region 110_1 (above the ground or on a top side of FIG. 4) in the second direction, the second extended active region 110_2 extends from another edge of the central active region 110_1 (on the top side of FIG. 4) in the second direction, the third extended active region 110_2c extends from another edge of the central active region 110_1 (on a bottom side of FIG. 4) in the second direction, and the fourth extended active region 1 10_2d extends from another edge of the central active region 110_1 (on the bottom side of FIG. 4) in the second direction. The first, second, third, and fourth extended active regions 110_2a, 110_2b, 110_2c, and 110_2d may have rectangular shapes on the X-Y plane.

In an implementation, the first extended active region 110_2a and the second extended active region 110_2b may be symmetrical to each other with respect to a virtual line S-S' passing through a center of the central active region 110_1, and the third extended active region 110_2c and the fourth extended active region 110_2d may be symmetrical to each other with respect to the virtual line S-S'.

Each of first, second, third, and fourth source regions Sa, Sb, Sc, and Sd may be in an upper portion of each of the first, second, third, and fourth extended active regions 110_2a, 110_2b, 110_2c, and 110_2d. In an implementation, the first source region Sa may be in the upper portion of the first extended active region 110_2a, the second source region Sb may be in the upper portion of the second extended active region 110_2b, the third source region Sc may be in the upper portion of the third extended active region 110_2c, and the fourth source region Sd may be in the upper portion of the fourth extended active region 110_2d. The first, second, third, and fourth extended active regions 110_2a, 110_2b, 110_2c, and 110_2d may be doped with a second impurity. The second impurity may include, e.g., an n-type impurity, such as P.

The first, second, third, and fourth source regions Sa, Sb, Sc, and Sd may be connected to first, second, third, and fourth contacts 130a, 130b, 130c, and 130d, respectively. The first, second, third, and fourth contacts 130a, 130b, 130c, and 130d may receive the operating voltage from the drain contact 140 and may transmit the operating voltage to the word line WL (refer to FIG. 1), the string selection line SSL (refer to FIG. 1), and the ground selection line GSL of the selected memory cell block. In an implementation, when a memory cell block (hereinafter, referred to as a first memory cell block) connected to the first contact 130a is selected, the first contact 130a may receive the operating voltage from the drain contact 140 and may transmit the operating voltage to a word line of the first memory cell block.

The first, second, third, and fourth gate structures 120a, 120b, 120c, and 120d are on the substrate 101 and spaced apart from one another. In an implementation, the first gate structure 120a may be on or overlie the first extended active region 110_2a of the substrate 101, the second gate structure 120b may be on or overlie the second extended active region 110_2b of the substrate 101, the third gate structure 120c may be on or overlie the third extended active region 110_2c of the substrate 101, and the fourth gate structure 120d may be on or overlie the fourth extended active region 110_2d of the substrate 101 so that the first, second, third, and fourth gate structures 120a, 120b, 120c, and 120d are spaced apart from one another.

Each of first, second, third, and fourth channel regions CHa, CHb, CHc, and CHd may be in an upper portion of each of the first, second, third, and fourth extended active regions 110_2a, 110_2b, 110_2c, and 110_2d overlapping or underlying each of the first, second, third, and fourth gate structures 120a, 120b, 120c, and 120d in a third direction (a Z direction) perpendicular to the first direction and the second direction. In an implementation, the first channel region CHa may be in the upper portion of the first extended active region 110_2a overlapping the first gate structure 120a in the third direction.

The first gate structure 120a may constitute the first pass transistor PTR1 together with the first source region Sa and the drain region D. The second gate structure 120b may constitute the second pass transistor PTR2 together with the second source region Sb and the drain region D. The third gate structure 120c may constitute the third pass transistor PTR3 together with the third source region Sc and the drain region D. The fourth gate structure 120d may constitute the fourth pass transistor PTR4 together with the fourth source region Sd and the drain region D. In an implementation, as described above, the first, second, third, and fourth pass transistors PTR1, PTR2, PTR3, and PTR4 share one (e.g., may all be electrically connected to a same) drain region D.

The first, second, third, and fourth pass transistors PTR1, PTR2, PTR3, and PTR4 may transmit the operating voltage to different memory cell blocks. In an implementation, one of the first, second, third, and fourth pass transistors PTR1, PTR2, PTR3, and PTR4 may transmit the operating voltage to one of the different memory cell blocks based on a memory cell block selection signal.

In an implementation, the first, second, third, and fourth pass transistors PTR1, PTR2, PTR3, and PTR4 may include high voltage pass transistors capable of transmitting high voltages to the memory cell blocks. The high voltage may be, e.g., about 10 V to about 30 V.

The first, second, third, and fourth gate structures 120a, 120b, 120c, and 120d may include the first, second, third, and fourth gate dielectric layers 120al, 120bl, 120cl, and 120dl and first, second, third, and fourth gate electrodes 120ag, 120bg, 120cg, and 120dg on the first, second, third, and fourth gate dielectric layers 120al, 120bl, 120cl, and 120dl, respectively. Each of the first, second, third, and fourth gate dielectric layers 120al, 120bl, 120cl, and 120dl may include, e.g., a silicon oxide layer, a silicon nitride layer, a silicon oxynitride layer, or a combination thereof. Each of the first, second, third, and fourth gate electrodes 120ag, 120bg, 120cg, and 120dg may include, e.g., aluminum (Al), silver (Ag), copper (Cu), molybdenum (Mo), chromium (Cr), tantalum (Ta), titanium (Ti), or a combination thereof.

In the substrate 101, an isolation region 160 may be under the device isolation layer 150. The isolation region 160 may be doped with a third impurity. The third impurity may include, e.g., a p-type impurity, such as boron (B). The isolation region 160 may electrically isolate the first, second, third, and fourth source regions Sa, Sb, Sc, and Sd from one another.

The isolation region 160 may include a first isolation region 160_1 surrounding the active region 110 and a first extended isolation region 160_2a and a second extended isolation region 160_2b extending (e.g., inwardly) from the first isolation region 160_1 toward the central active region 110_1 in the second direction. The first extended isolation region 160_2a and the second extended isolation region 160_2b may be symmetrical to each other with respect to the virtual line S-S'. In an implementation, the first extended isolation region 160_2a may extend in the second direction and may pass between the first contact 130a and the second contact 130b, and the second extended isolation region 160_2b may extend in the second direction and may pass between the third contact 130c and the fourth contact 130d. In an implementation, the first extended isolation region 160_2a may electrically isolate the first contact 130a from the second contact 130b, and the second extended isolation region 160_2b may electrically isolate the third contact 130c from the fourth contact 130d. In an implementation, as illustrated in FIG. 4, the first extended isolation region 160_2a may extend in the second direction to be (e.g., at least partially) between the first gate structure 120a and the second gate structure 120b, and the second extended isolation region 160_2b may extend in the second direction to be (e.g., at least partially) between the third gate structure 120c and the fourth gate structure 120d. In an implementation, the first extended isolation region 160_2a and the second extended isolation region 160_2b may extend more or less.

The semiconductor device 100 according to an embodiment includes the active region 110 having an H shape and the first to fourth gate structures 120a, 120b, 120c, and 120d on the active region 110. In an implementation, the active region 110 and the first to fourth gate structures 120a, 120b, 120c, and 120d constitute the first to fourth pass transistors PTR1, PTR2, PTR3, and PTR4 and share one drain region of the active region 110. In an implementation, areas of the first to fourth pass transistors PTR1, PTR2, PTR3, and PTR4 may be reduced, when compared to other semiconductor devices constituted by an active region and two gate structures on the active region and including two pass transistors sharing one drain region of the active region. In addition, compared to other semiconductor devices, in the semiconductor device 100 according to an embodiment, a distance between neighboring drain contacts 140 or a distance between a drain contact 140 and a neighboring one of the first to fourth gate structures 120a, 120b, 120c, and 120d may increase, so that electrical isolation between neighboring drain contacts 140 or between the drain contact 140 and the neighboring one of the first to fourth gate structures 120a, 120b, 120c, and 120d may be well achieved. Accordingly, the performance and reliability of the semiconductor device 100 according to an embodiment may be improved.

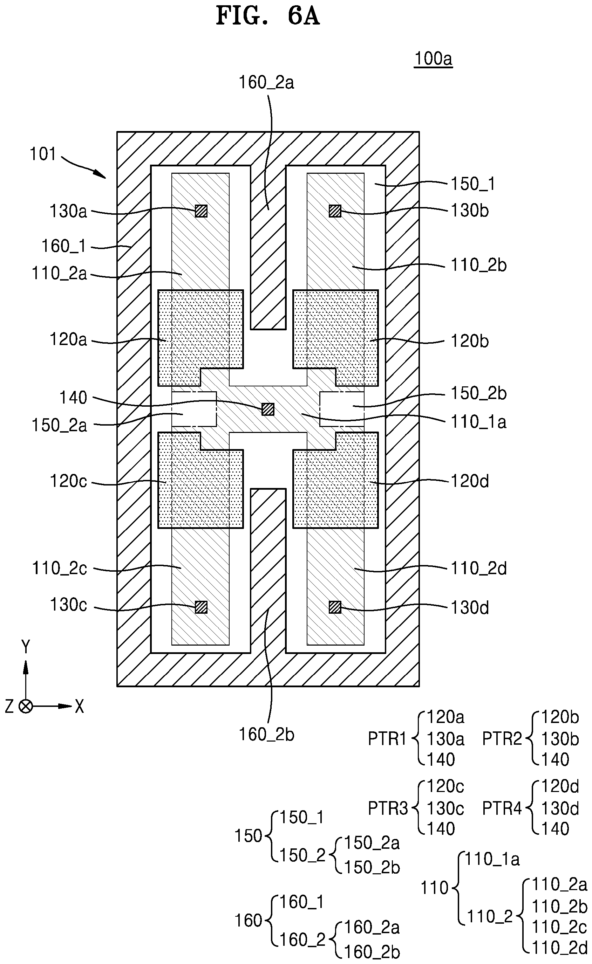

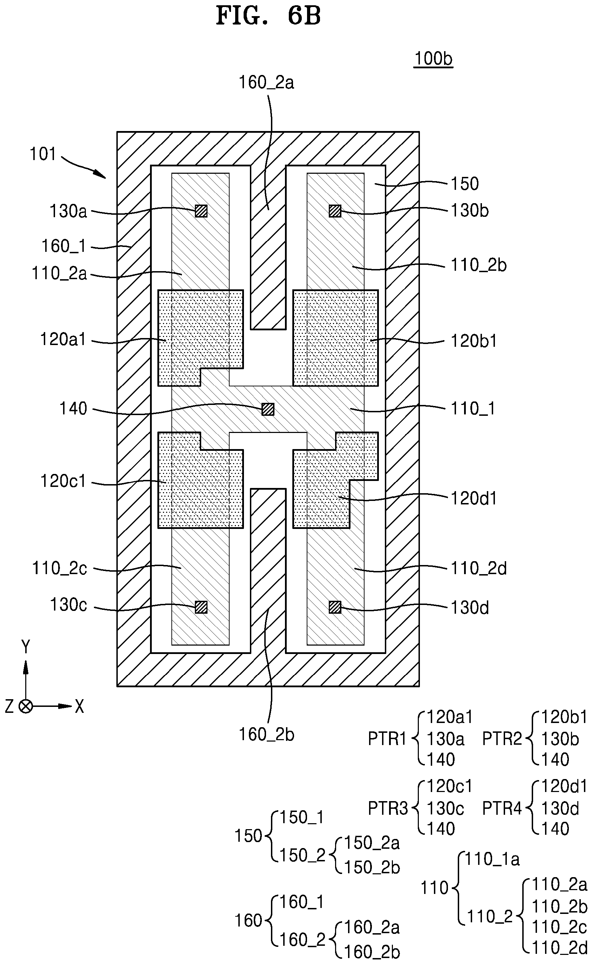

FIGS. 6A and 6B are layout diagrams illustrating semiconductor devices 100a and 100b according to embodiments. Because components of each of the semiconductor device 100a of FIG. 6A and the semiconductor device 100b of FIG. 6B are similar to the components of the semiconductor device 100 described with reference to FIGS. 4, 5A, and 5B, differences are mainly described hereinafter.

Referring to FIG. 6A, the semiconductor device 100a includes a substrate 101 and first to fourth gate structures 120a, 120b, 120c, and 120d. The semiconductor device 100a may be in or on the peripheral circuit structure PS described with reference to FIG. 3.

An active region 110 is defined on the substrate 101 by a device isolation layer 150. The active region 110 includes a central active region 110_1a and first, second, third, and fourth extended active regions 110_2a, 110_2b, 110_2c, and 110_2d.

In an implementation, the device isolation layer 150 may include a first device isolation layer 150_1 and a first extended device isolation layer 150_2a and a second extended device isolation layer 150_2b extending (e.g., inwardly) from the first device isolation layer 150_1 through a part of the central active region 110_1a in the first direction. The first extended device isolation layer 150_2a may electrically isolate the first gate structure 120a from the third gate structure 120c, and the second extended device isolation layer 150_2b may electrically isolate the second gate structure 120b from the fourth gate structure 120d. Accordingly, a coupling phenomenon between the first gate structure 120a and the third gate structure 120c and a coupling phenomenon between the second gate structure 120b and the fourth gate structure 120d may be improved or reduced.

Referring to FIG. 6B, the semiconductor device 100b includes a substrate 101 and first to fourth gate structures 120a1, 120b1, 120c1, and 120d1. The semiconductor device 100b may be arranged in the peripheral circuit structure PS described with reference to FIG. 3.

In an implementation, each of the first to fourth gate structures 120a1, 120b1, 120c1, and 120d1 may independently have, e.g., a rectangular shape, an L shape, or a Z shape. In an implementation, as illustrated in FIG. 6B, the first gate structure 120a1 and the third gate structure 120c1 may have an L shape or a rotated L shape, the second gate structure 120b1 may have a rectangular shape, and the fourth gate structure 120d1 may have a Z shape. Depending on the shape of each of the first to fourth gate structures 120a1, 120b1, 120c1, and 120d1, a gate length of each of the first to fourth gate structures 120a1, 120b1, 120c1, and 120d1 may vary. In an implementation, by changing the shape of each of the first to fourth gate structures 120a1, 120b1, 120c1, and 120d1, the gate length of each of the first to fourth gate structures 120a1, 120b1, 120c1, and 120d1 may be adjusted to help reduce or prevent leakage current and to improve the performance of the semiconductor device 100b.

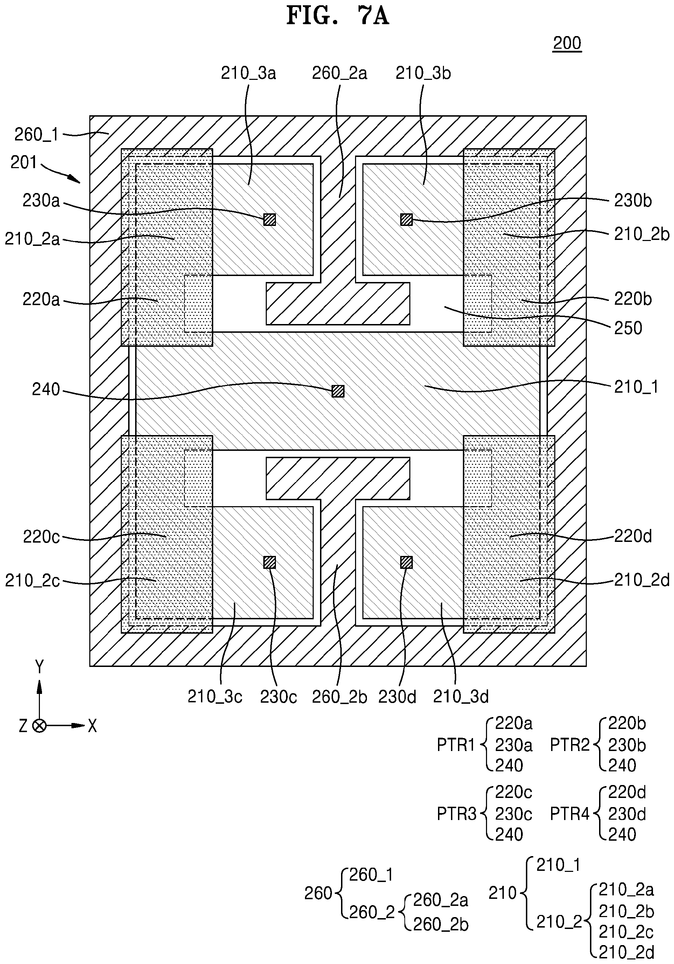

FIG. 7A is a layout diagram illustrating a semiconductor device 200 according to an embodiment. Because components of the semiconductor device 200 of FIG. 7A are similar to the components of the semiconductor device 100 described with reference to FIGS. 4, 5A, and 5B, differences are mainly described hereinafter.

Referring to FIG. 7A, the semiconductor device 200 include a substrate 201 and first to fourth gate structures 220a, 220b, 220c, and 220d. The semiconductor device 200 may be in or on the peripheral circuit structure PS described with reference to FIG. 3.

An active region 210 is defined on the substrate 201 by a device isolation layer 250. First, second, third, and fourth pass transistors PTR1, PTR2, PTR3, and PTR4 are configured on the active region 210.

The active region 210 includes a central active region 210_1, first, second, third, and fourth extended active regions 210_2a, 210_2b, 210_2c, and 210_2d, and may include first, second, third, and fourth protruding active regions 210_3a, 210_3b, 210_3c, and 210_3d. In an implementation, the central active region 210_1, the first, second, third, and fourth extended active regions 210_2a, 210_2b, 210_2c, and 210_2d, and the first, second, third, and fourth protruding active regions 210_3a, 210_3b, 210_3c, and 210_3d (e.g., the active region 210) may have an H shape.

The central active region 210_1 extends in the first direction (the X direction). A drain region D may be in an upper portion of the central active region 210_1. The drain region may be substantially the same as or similar to the drain region D described with reference to FIGS. 4, 5A, and 5B. The drain region D may be connected to a drain contact 240. In an implementation, the drain contact 240 may be on the X-Y plane in an oblique direction with the first to fourth gate structures 220a, 220b, 220c, and 220d.

The first, second, third, and fourth extended active regions 210_2a, 210_2b, 210_2c, and 210_2d extend from the central active region 210_1 in the second direction (the Y direction) perpendicular to the first direction.

Each of first, second, third, and fourth source regions may be in an upper portion of each of the first, second, third, and fourth extended active regions 210_2a, 210_2b, 210_2c, and 210_2d. The first, second, third, and fourth source regions may be substantially the same as or similar to the first, second, third, and fourth source regions Sa, Sb, Sc, and Sd described with reference to FIGS. 4, 5A, and 5B. The first, second, third, and fourth source regions may be connected to first, second, third, and fourth contacts 230a, 230b, 230c, and 230d, respectively.

The first, second, third, and fourth protruding active regions 210_3a, 210_3b, 210_3c, and 210_3d may protrude (e.g., inwardly) from the first, second, third, and fourth extended active regions 210_2a, 210_2b, 210_2c, and 210_2d, respectively, in the first direction. The first, second, third, and fourth protruding active regions 210_3a, 210_3b, 210_3c, and 210_3d may protrude in the first direction to cross the first, second, third, and fourth gate structures 220a, 220b, 220c, and 220d on the X-Y plane. In an implementation, parts of the first, second, third, and fourth protruding active regions 210_3a, 210_3b, 210_3c, and 210_3d may overlap parts of the first, second, third, and fourth gate structures 220a, 220b, 220c, and 220d in the first direction. In an implementation, a gate length of each of the first, second, third, and fourth gate structures 220a, 220b, 220c, and 220d may increase, thereby helping to reduce or prevent leakage current.

The first, second, third, and fourth gate structures 220a, 220b, 220c, and 220d may be on the substrate 201 and spaced apart from one another. Configurations of the first, second, third, and fourth gate structures 220a, 220b, 220c, and 220d may be substantially the same as or similar to those of the first, second, third, and fourth gate structures 120a, 120b, 120c, and 120d described with reference to FIGS. 4, 5A, and 5B. Each of first, second, third, and fourth channel regions may be in an upper portion of each of the first, second, third, and fourth extended active regions 210_2a, 210_2b, 210_2c, and 210_2d overlapping each of the first, second, third, and fourth gate structures 220a, 220b, 220c, and 220d in the third direction (the Z direction) perpendicular to the first direction and the second direction. The first, second, third, and fourth channel regions may be substantially the same as or similar to the first, second, third, and fourth channel regions CHa, CHb, CHc, and CHd described with reference to FIGS. 4, 5A, and 5B.

The first gate structure 220a may constitute the first pass transistor PTR1 together with the first source region and the drain region. The second gate structure 220b may constitute the second pass transistor PTR2 together with the second source region and the drain region. The third gate structure 220c may constitute the third pass transistor PTR3 together with the third source region and the drain region. The fourth gate structure 220d may constitute the fourth pass transistor PTR4 together with the fourth source region and the drain region. In an implementation, as described above, the first, second, third, and fourth pass transistors PTR1, PTR2, PTR3, and PTR4 share the drain region D.

In the substrate 201, an isolation region 260 may be under the device isolation layer 250. The isolation region 260 may include a first isolation region 260_1 surrounding the active region 210 and a first extended isolation region 260_2a and a second extended isolation region 260_2b extending from the first isolation region 260_1 toward the central active region 210_1 in the second direction. In an implementation, each of the first extended isolation region 260_2a and the second extended isolation region 260_2b may have a T shape. In an implementation, the first extended isolation region 260_2a may have a shape in which a T-shape is rotated by 180 degrees, and the second extended isolation region 260_2b may have a T shape.

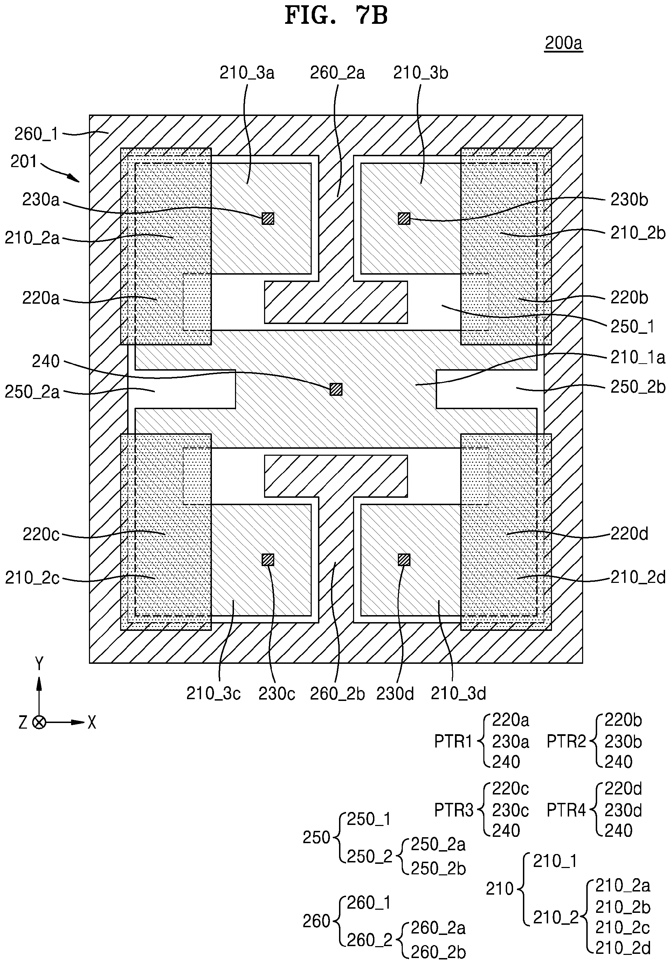

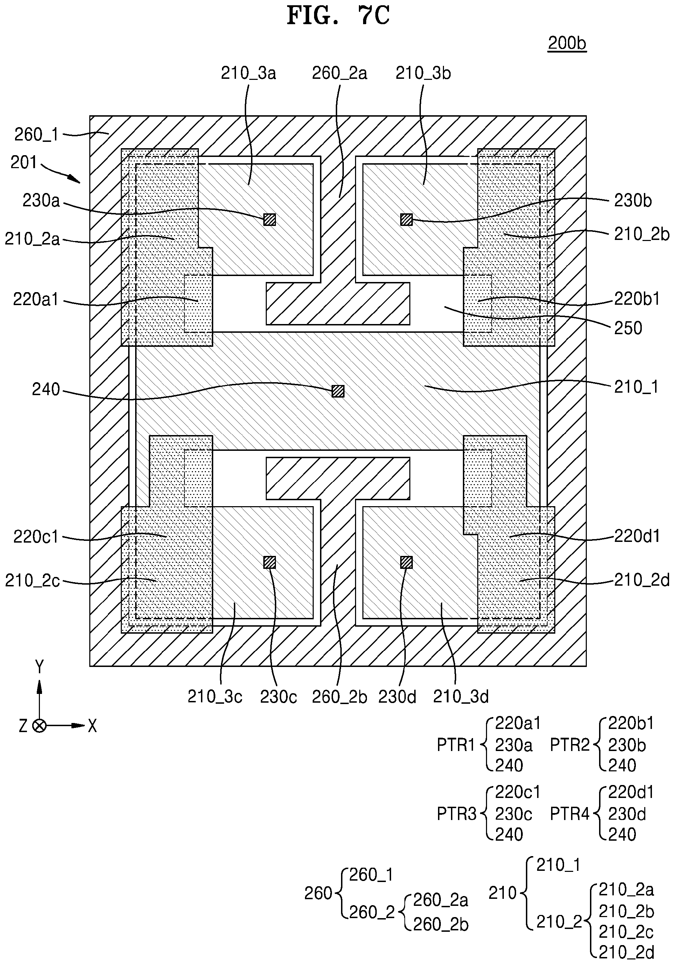

FIGS. 7B and 7C are layout diagrams illustrating semiconductor devices 200a and 200b according to embodiments. Because components of each of the semiconductor devices 200a and 200b of FIGS. 7B and 7C are similar to the components of the semiconductor device 200 described with reference to FIG. 7A, differences are mainly described hereinafter.

Referring to FIG. 7B, the semiconductor device 200a may include a substrate 201 and first to fourth gate structures 220a, 220b, 220c, and 220d. The semiconductor device 200a may be in or on the peripheral circuit structure PS described with reference to FIG. 3.

An active region 210 is defined on the substrate 201 by a device isolation layer 250. The active region 210 includes a central active region 210_1, first, second, third, and fourth extended active regions 210_2a, 210_2b, 210_2c, and 210_2d, and may include first, second, third, and fourth protruding active regions 210_3a, 210_3b, 210_3c, and 210_3d.

In an implementation, the device isolation layer 250 may include a first device isolation layer 250_1 and a first extended device isolation layer 250_2a and a second extended device isolation layer 250_2b extending from the first device isolation layer 250_1 through a part of the central active region 210_1a in the first direction. The first extended device isolation layer 250_2a may electrically isolate the first gate structure 220a from the third gate structure 220c, and the second extended device isolation layer 250_2b may electrically isolate the second gate structure 220b from the fourth gate structure 220d.

Referring to FIG. 7C, the semiconductor device 200b includes a substrate 201 and first to fourth gate structures 220a1, 220b1, 220c1, and 220d1. The semiconductor device 200b may be in or on the peripheral circuit structure PS described with reference to FIG. 3.

In an implementation, each of the first to fourth gate structures 220a1, 220b1, 220c1, and 220d1 may independently have, e.g., a rectangular shape, an L shape, or a Z shape. In an implementation, as illustrated in FIG. 7C, each of the first gate structure 220a1, the second gate structure 220b1, and the third gate structure 220c1 may have an L shape or a mirror image of the L shape, and the fourth gate structure 120d1 may have a Z shape.

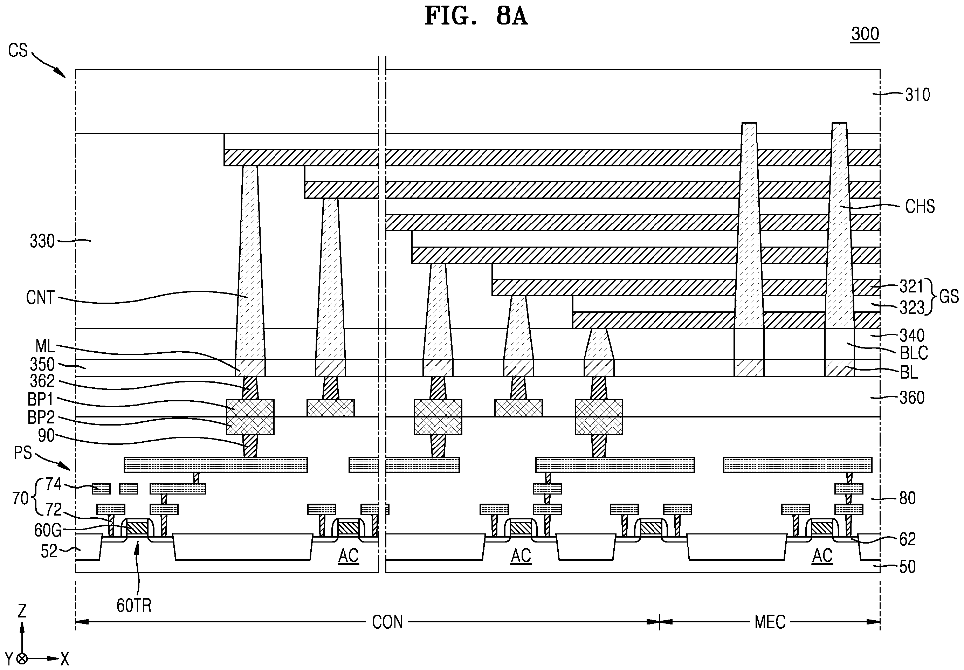

FIG. 8A is a cross-sectional view illustrating a semiconductor device 300 according to an embodiment.

Referring to FIG. 8A, the semiconductor device 300 may include a cell array structure CS and a peripheral circuit structure PS overlapping each other in the vertical direction (the Z direction). The cell array structure CS may include a memory cell region MEC and a connection region CON on one side of the memory cell region MEC in the first horizontal direction (the X direction).

In an implementation, the semiconductor device 100 may have a chip to chip (C2C) structure. The C2C structure may be obtained by forming the cell array structure CS on a first wafer, forming the peripheral circuit structure PS on a second wafer that is different from the first wafer, and then connecting the cell array structure CS to the peripheral circuit structure PS by a bonding method. In an implementation, in the bonding method, a plurality of first bonding pads BP1 of the cell array structure CS may be respectively bonded to a plurality of second bonding pads BP2 of the peripheral circuit structure PS to be electrically connected to the plurality of second bonding pads BP2 of the peripheral circuit structure PS. In an implementation, the plurality of first bonding pads BP1 and the plurality of second bonding pads BP2 may include copper (Cu), and the bonding method may include a Cu-Cu bonding method. In an implementation, the plurality of first bonding pads BP1 and the plurality of second bonding pads BP2 may include Al or tungsten (W).

The peripheral circuit structure PS may include a substrate 50, a plurality of peripheral circuit transistors 60TR on the substrate 50, and a plurality of peripheral circuit wiring structures 70.

The substrate 50 may include a semiconductor substrate. In an implementation, the substrate 50 may include Si, Ge, or SiGe. An active region AC may be defined in the substrate 50 by a device isolation layer 52, and the plurality of peripheral circuit transistors 60TR may be on the active region AC. Each of the plurality of peripheral circuit transistors 60TR may include a peripheral circuit gate 60G and source/drain regions 62 in parts of the substrates 50 on both sides of the peripheral circuit gate 60G. In an implementation, the plurality of peripheral circuit transistors 60TR may include a structure described above with respect to the first, second, third, and fourth pass transistors PTR1, PTR2, PTR3, and PTR4 included in the semiconductor devices 100, 100a, 100b, 200a, 200b, and 200c with reference to FIGS. 4 to 7C.

The plurality of peripheral circuit wiring structures 70 may include a plurality of peripheral circuit contacts 72 and a plurality of peripheral circuit wiring layers 74, respectively. At least some of the plurality of peripheral circuit wiring layers 74 may be electrically connected to the plurality of peripheral circuit transistors 60TR. The plurality of peripheral circuit contacts 72 may interconnect some of the plurality of peripheral circuit transistors 60TR to the plurality of peripheral circuit wiring layers 74. The plurality of peripheral circuit transistors 60TR and the plurality of peripheral circuit wiring structures 70 included in the peripheral circuit structure PS may be covered with an interlayer insulating layer 80. The interlayer insulating layer 80 may include a silicon oxide layer, a silicon nitride layer, a SiON layer, a SiOCN layer, or a combination thereof.

The plurality of second bonding pads BP2 may be on the interlayer insulating layer 80. The plurality of second bonding pads BP2 may be connected to the plurality of peripheral circuit wiring structures 70 through a plurality of second bonding vias 90, respectively. In an implementation, top surfaces of the plurality of second bonding pads BP2 may be coplanar with a top surface of the interlayer insulating layer 80. The plurality of second bonding pads BP2 may include a conductive material including Cu, gold (Au), Ag, Al, W, Ti, Ta, or a combination thereof.

The cell array structure CS may include a cell stack structure GS. The cell stack structure GS may include a plurality of gate electrodes 321 and a plurality of insulating layers 323 alternately arranged in the vertical direction. The plurality of gate electrodes 321 may include, e.g., W, nickel (Ni), cobalt (Co), Ta, tungsten nitride, titanium nitride, tantalum nitride, or a combination thereof. The plurality of insulating layers 323 may include silicon oxide, silicon nitride, or silicon oxynitride. The plurality of gate electrodes 321 may correspond to the ground selection line GSL, the word line WL, and the at least one string selection line SSL constituting the memory cell string MS (refer to FIG. 2). In an implementation, in FIG. 8A, the uppermost gate electrode 321 may function as the ground selection line GSL, the lowermost two gate electrodes 321 may function as the string selection line SSL, and the remaining gate electrodes 321 may function as the word line WL. In an implementation, the memory cell string MS, in which the ground selection transistor GST, the string selection transistor SST, and the plurality of memory cell transistors MC1, MC2, ..., MCn-1 and MCn between the ground selection transistor GST and the string selection transistor SST are serially connected to one another, may be provided.

The cell stack structure GS may extend on the connection region CON to have a shorter length in the first horizontal direction (the X direction) away from a substrate 310. In an implementation, the cell stack structure GS may have a stepped shape.

The cell stack structure GS may be covered with a cover insulating layer 330. The cover insulating layer 330 may include a silicon oxide layer, a silicon nitride layer, or a combination thereof.

A plurality of channel structures CHS may extend on the memory cell region MEC and through the cell stack structure GS in the vertical direction. The plurality of channel structures CHS may be spaced apart from one another at a predetermined interval. The plurality of channel structures CHS may be arranged in a zigzag pattern or a staggered pattern. In an implementation, the plurality of channel structures CHS may extend to the inside of, e.g., into, the substrate 310. In an implementation, the plurality of channel structures CHS may contact a bottom surface of the substrate 310.

Each of the plurality of channel structures CHS may be in a channel hole. Each of the plurality of channel structures CHS may include a gate insulating layer, a channel layer, a buried insulating layer, and a conductive plug.

The gate insulating layer and the channel layer may be sequentially arranged on a side wall of the channel hole. The buried insulating layer filling a residual space of the channel hole may be arranged on the channel layer. The conductive plug may contact the channel layer to block an entrance of the channel hole.

The plurality of channel structures CHS may contact a plurality of bit line contacts BLC on bottom surfaces thereof. The plurality of bit line contacts BLC may extend through a first insulating layer 340 in the vertical direction and may be insulated from one another by the first insulating layer 340. The plurality of bit line contacts BLC may respectively contact a plurality of bit lines BL on bottom surfaces thereof. The plurality of bit lines BL may extend through a second insulating layer 350 in the vertical direction and may be insulated from one another by the second insulating layer 350. Each of the plurality of channel structures CHS may be connected to one corresponding bit line BL among the plurality of bit lines BL through each of the plurality of bit line contacts BLC.

A plurality of contact structures CNT may extend on the connection region CON through the cover insulating layer 330 and the first insulating layer 340 in the vertical direction. The plurality of contact structures CNT may respectively contact a plurality of wiring layers ML on bottom surfaces thereof. The plurality of wiring layers ML may extend through the second insulating layer 350 in the vertical direction and may be insulated from one another by the second insulating layer 350. The plurality of wiring layers ML may respectively contact a plurality of first bonding vias 362 on bottom surfaces thereof. The plurality of first bonding vias 362 may extend through an interlayer insulating layer 360 in the vertical direction and may be insulated from one another by the interlayer insulating layer 360. The plurality of first bonding vias 362 may respectively contact the plurality of first bonding pads BP1 on bottom surfaces thereof.

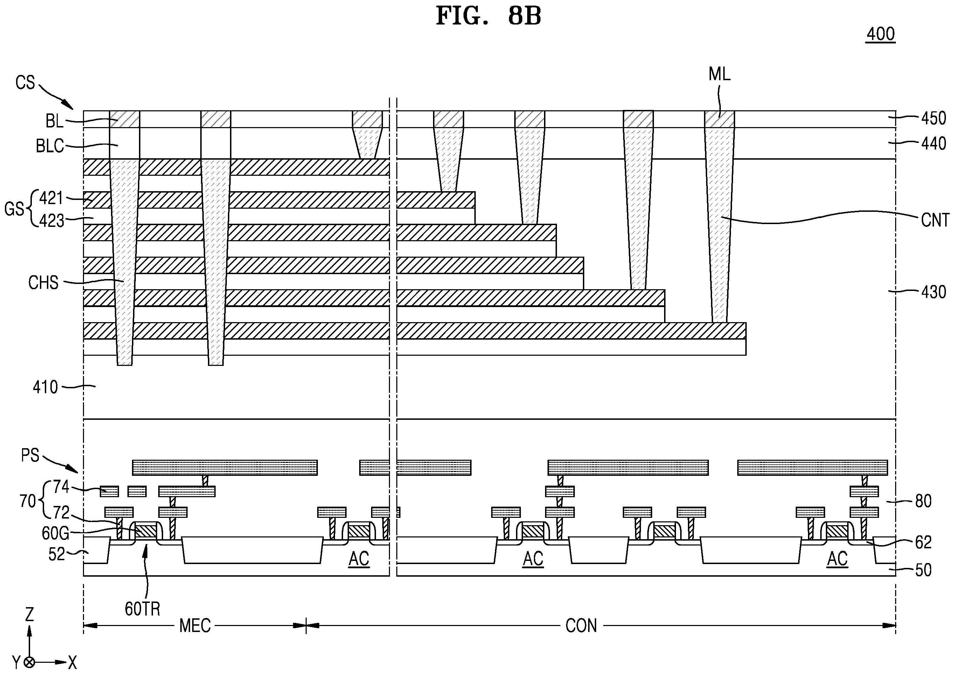

FIG. 8B is a cross-sectional view illustrating a semiconductor device 400 according to an embodiment. Because components of the semiconductor device 400 of FIG. 8B are similar to the components of the semiconductor device 300 described with reference to FIG. 8A, differences are mainly described hereinafter.

Referring to FIG. 8B, the semiconductor device 400 may include a cell array structure CS and a peripheral circuit structure PS.

The peripheral circuit structure PS of the semiconductor device 400 may be substantially the same as or similar to the peripheral circuit structure PS of the semiconductor device 300 described with reference to FIG. 8A.

The cell array structure CS may include a cell stack structure GS and a cell substrate 410 between the cell stack structure GS and the peripheral circuit structure PS. In an implementation, the cell substrate 410 may include a semiconductor material, e.g., polysilicon.

The cell stack structure GS may be on the cell substrate 410. The cell stack structure GS may include a plurality of gate electrodes 421 and a plurality of insulating layers 423 alternately arranged in the vertical direction. The cell stack structure GS may extend on a connection region CON to have a length decreasing in the first horizontal direction (the X direction) away from the substrate 410. In an implementation, the cell stack structure GS may have a stepped shape. The cell stack structure GS may be covered with a cover insulating layer 430.

A plurality of channel structures CHS may extend on a memory cell region MEC through the cell stack structure GS in the vertical direction. A configuration of the plurality of channel structures CHS may be substantially the same as or similar to that of the plurality of channel structures CHS described with reference to FIG. 8A.

In an implementation, the plurality of channel structures CHS may extend to the inside of the cell substrate 410. In an implementation, the plurality of channel structures CHS may contact a bottom surface of the cell substrate 410.

The plurality of channel structures CHS may respectively contact a plurality of bit line contacts BLC on top surfaces thereof. The plurality of bit line contacts BLC may extend through a first insulating layer 440 in the vertical direction and may be insulated from one another by the first insulating layer 440. The plurality of bit line contacts BLC may contact a plurality of bit lines BL on top surfaces thereof. The plurality of bit lines BL may extend through a second insulating layer 450 in the vertical direction and may be insulated from one another by the second insulating layer 450. Each of the plurality of channel structures CHS may be connected to one corresponding bit line BL among the plurality of bit lines BL through each of the plurality of bit line contacts BLC.

A plurality of contact structures CNT may extend on the connection region CON through the cover insulating layer 430 and the first insulating layer 440 in the vertical direction. The plurality of contact structures CNT may contact a plurality of wiring layers ML on top surfaces thereof. The plurality of wiring layers ML may extend through the second insulating layer 450 in the vertical direction and may be insulated from one another by the second insulating layer 450.

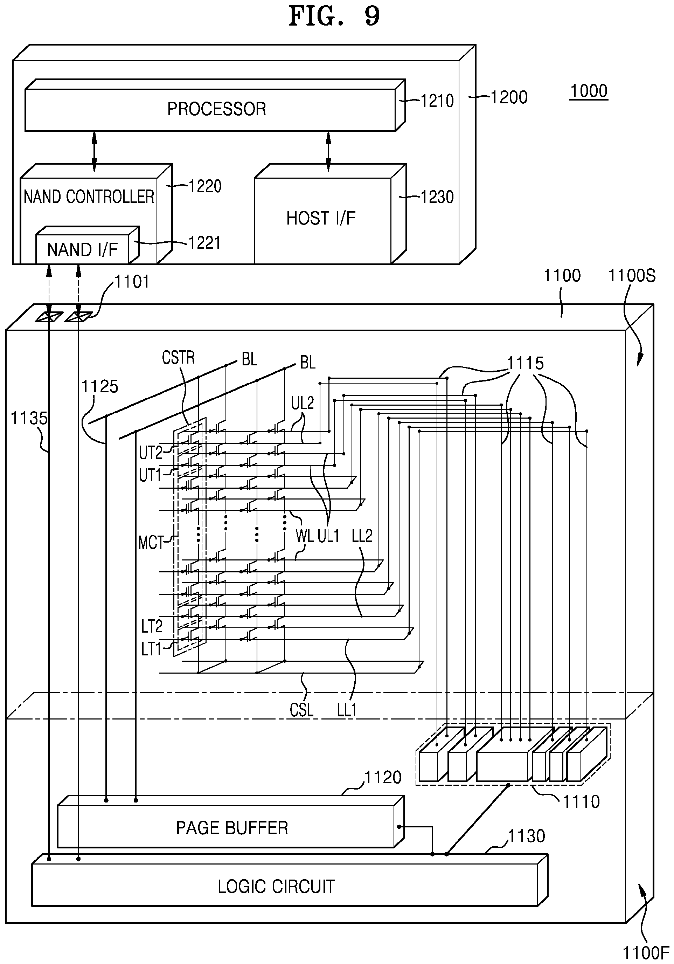

FIG. 9 is a diagram schematically illustrating an electronic system 1000 including a semiconductor device according to an embodiment.

Referring to FIG. 9, the electronic system 1000 according to an embodiment may include a semiconductor device 1100 and a controller 1200 electrically connected to the semiconductor device 1100. The electronic system 1000 may include a storage device including one or a plurality of semiconductor devices 1100 or an electronic device including the storage device. In an implementation, the electronic system 1000 may include a solid state drive (SSD) device including at least one semiconductor device 1100, a universal serial bus (USB) device, a computing system, a medical device, or a communication device.

The semiconductor device 1100 may include a non-volatile memory device. In an implementation, the semiconductor device 1100 may include a NAND flash memory device including a structure described above for the semiconductor devices 100, 100a, 100b, 200, 200a, 200b, 300, and 400 with reference to FIGS. 4 to 8B. The semiconductor device 1100 may include a first structure 1100F and a second structure 1100S on the first structure 1100F. In an implementation, the first structure 1100F may be next to the second structure 1100S. The first structure 1100F may include a peripheral circuit structure including a decoder circuit 1110, a page buffer 1120, and a logic circuit 1130. The second structure 1100S may include a memory cell structure including a bit line BL, a common source line CSL, a plurality of word lines WL, first and second gate upper lines LTL1 and UL2, first and second gate lower lines LL1 and LL2, and a plurality of memory cell strings CSTR between the bit line BL and the common source line CSL.

In the second structure 1100S, each of the plurality of memory cell strings CSTR may include lower transistors LT1 and LT2 adjacent to the common source line CSL, upper transistors UT1 and UT2 adjacent to the bit line BL, and a plurality of memory cell transistors MCT between the lower transistors LT1 and LT2 and the upper transistors UT1 and UT2. The number of lower transistors LT1 and LT2 and the number of upper transistors UT1 and UT2 may vary according to embodiments.

In an implementation, the upper transistors UT1 and UT2 may include string selection transistors, and the lower transistors LT1 and LT2 may include ground selection transistors. The first and second gate lower lines LL1 and LL2 may include gate electrodes of the lower transistors LT1 and LT2, respectively. The plurality of word lines WL may include gate electrodes of the plurality of memory cell transistors MCT, and the first and second gate upper lines LTL1 and UL2 may include gate electrodes of the upper transistors UT1 and UT2.

The common source line CSL, the first and second gate lower lines LL1 and LL2, the plurality of word lines WL, and the first and second gate upper lines LTL1 and UL2 may be electrically connected to the decoder circuit 1110 through a plurality of first connection wires extending from the first structure 1100F to the second structure 1100S. The plurality of bit lines BL may be electrically connected to the page buffer 1120 through a plurality of second connection wires extending from the first structure 1100F to the second structure 1100S.

In the first structure 1100F, the decoder circuit 1110, and the page buffer 1120 may perform a control operation on at least one of the plurality of memory cell transistors MCT. The decoder circuit 1110 and the page buffer 1120 may be controlled by the logic circuit 1130.

The semiconductor device 1100 may communicate with the controller 1200 through input/output pads 1101 electrically connected to the logic circuit 1130. The input/output pads 1101 may be electrically connected to the logic circuit 1130 through input/output connection wires 1135 extending from the first structure 1100F to the second structure 11005.

The controller 1200 may include a processor 1210, a NAND controller 1220, and a host interface 1230. In an implementation, the electronic system 1000 may include a plurality of semiconductor devices 1100. In this case, the controller 1200 may control the plurality of semiconductor devices 1100.

The processor 1210 may control the overall operation of the electronic system 1000 including the controller 1200. The processor 1210 may operate according to predetermined firmware, and may control the NAND controller 1220 to access the plurality of semiconductor devices 1100. The NAND controller 1220 may include a NAND interface 1221 processing communication with the plurality of semiconductor devices 1100. Through the NAND interface 1221, a control command for controlling the plurality of semiconductor devices 1100, data to be stored in the plurality of memory cell transistors MCT of the plurality of semiconductor devices 1100, and data to be read from the plurality of memory cell transistors MCT of the plurality of semiconductor devices 1100 may be transmitted. The host interface 1230 may provide a communication function between the electronic system 1000 and an external host. When the control command is received from the external host through the host interface 1230, the processor 1210 may control the plurality of semiconductor devices 1100 in response to the control command.

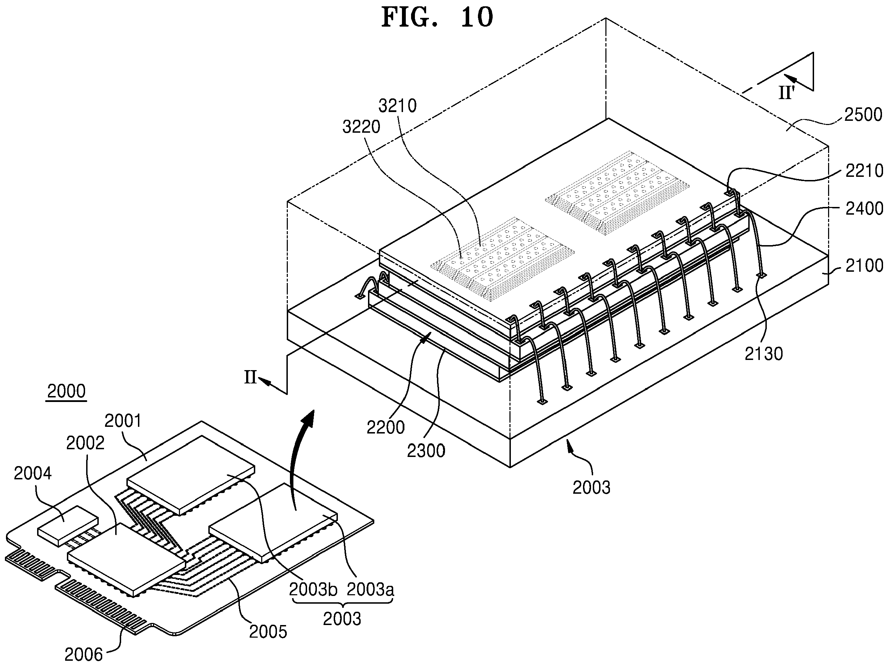

FIG. 10 is a perspective view schematically illustrating an electronic system 2000 including a semiconductor device according to an embodiment.

Referring to FIG. 10, the electronic system 2000 according to the embodiment may include a main substrate 2001, a controller 2002 mounted on the main substrate 2001, at least one semiconductor package 2003, and dynamic random access memory (DRAM) 2004. The semiconductor package 2003 and the DRAM 2004 may be connected to the controller 2002 by a plurality of wiring patterns 2005 formed on the main substrate 2001.

The main substrate 2001 may include a connector 2006 including a plurality of pins coupled to an external host. The number and arrangement of pins in the connector 2006 may vary depending on a communication interface between the electronic system 2000 and the external host. In an implementation, the electronic system 2000 may communicate with the external host according to one of interfaces, such as a USB, peripheral component interconnect express (PCI-Express), serial advanced technology attachment (SATA), and M-Py for a universal flash storage (UFS). In an implementation, the electronic system 2000 may be operated by power supplied from the external host through the connector 2006. The electronic system 2000 may further include a power management integrated circuit (PMIC) distributing power supplied from the external host to the controller 2002 and the semiconductor package 2003.

The controller 2002 may store data in the semiconductor package 2003 or may read data from the semiconductor package 2003, and may increase an operating speed of the electronic system 2000.

The DRAM 2004 may include buffer memory for reducing a speed difference between the semiconductor package 2003 as a data storage space and the external host. The DRAM 2004 included in the electronic system 2000 may operate as a kind of cache memory, and may provide a space for temporarily storing data in a control operation for the semiconductor package 2003. When the electronic system 2000 includes the DRAM 2004, the controller 2002 may further include a DRAM controller for controlling the DRAM 2004 in addition to a NAND controller for controlling the semiconductor packages 2003.

The semiconductor package 2003 may include first and second semiconductor packages 2003a and 2003b apart from each other. Each of the first and second semiconductor packages 2003a and 2003b may include a semiconductor package including a plurality of semiconductor chips 2200. Each of the first and second semiconductor packages 2003a and 2003b may include a package substrate 2100, the plurality of semiconductor chips 2200 on the package substrate 2100, an adhesive layer 2300 on a bottom surface of each of the plurality of semiconductor chips 2200, connection structures 2400 electrically connecting the plurality of semiconductor chips 2200 to the package substrate 2100, and a molding layer 2500 covering the plurality of semiconductor chips 2200 and the connection structures 2400 on the package substrate 2100.

The package substrate 2100 may include a printed circuit board (PCB) including a plurality of package upper pads 2130. Each of the plurality of semiconductor chips 2200 may include input/output pads 2210. The input/output pads 2210 may correspond to the input/output pads 1101 of FIG. 9. Each of the plurality of semiconductor chips 2200 may include a plurality of gate stacks 3210 and a plurality of channel structures 3220. Each of the plurality of semiconductor chips 2200 may include a structure described above for the semiconductor devices 100, 100a, 100b, 200, 200a, 200b, 300, and 400 with reference to FIGS. 4 to 8B.

In an implementation, the connection structures 2400 may include bonding wires electrically connecting the input/output pads 2210 to the plurality of package upper pads 2130. Accordingly, in the first and second semiconductor packages 2003a and 2003b, the plurality of semiconductor chips 2200 may be electrically connected to one another by a bonding wire method and may be electrically connected to the plurality of package upper pads 2130 of the package substrate 2100. In an implementation, in the first and second semiconductor packages 2003a and 2003b, the plurality of semiconductor chips 2200 may be electrically connected to one another by a connection structure including a through silicon via (TSV) instead of the connection structures 2400 in the bonding wire method.

In an implementation, the controller 2002 and the plurality of semiconductor chips 2200 may be included in one package. In an implementation, the controller 2002 and the plurality of semiconductor chips 2200 may be mounted on a separate interposer substrate that is different from the main substrate 2001, and the controller 2002 may be connected to the plurality of semiconductor chips 2200 by wiring formed on the interposer substrate.

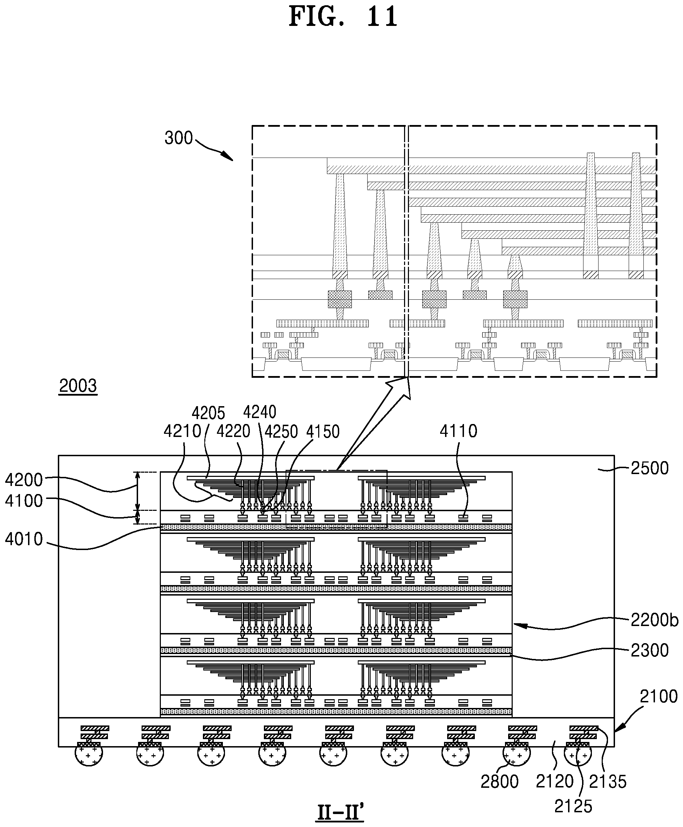

FIG. 11 is a cross-sectional view schematically illustrating a semiconductor package 2003 according to an embodiment. FIG. 11 illustrates a configuration taken along the line II-II' of FIG. 10 in more detail.

Referring to FIG. 11, in the semiconductor package 2003, each of semiconductor chips 2200b may include a semiconductor substrate 4010, a first structure 4100 on the semiconductor substrate 4010, and a second structure 4200 bonded to the first structure 4100 on the first structure 4100 by wafer bonding.

The first structure 4100 may include a peripheral circuit region including peripheral wires 4110 and first bonding structures 4150. The second structure 4200 may include a common source line 4205, a gate stack structure 4210 between the common source line 4205 and the first structure 4100, memory channel structures 4220 passing through the gate stack structure 4210, and second bonding structures 4250 electrically connected to the memory channel structures 4220 and the word lines WL (refer to FIG. 9) of the gate stack structure 4210. In an implementation, the second bonding structures 4250 may be electrically connected to the memory channel structures 4220 and the word lines WL (refer to FIG. 9) through bit lines 4240 electrically connected to the memory channel structures 4220 and gate connection wires electrically connected to the word lines WL

(refer to FIG. 9). The first bonding structures 4150 of the first structure 4100 and the second bonding structures 4250 of the second structure 4200 may be bonded while contacting each other. Bonded portions of the first bonding structures 4150 and the second bonding structures 4250 may include, e.g., Cu.

Each of the semiconductor chips 2200b may further include the input/output pads 2210 (refer to FIG. 10) electrically connected to the peripheral wires 4110 of the first structure 4100.

In an implementation, referring to FIG. 10, the semiconductor chips 2200 may be electrically connected to the semiconductor chips 2200b of FIG. 11 by the connection structures 2400 in the form of bonding wires. In an implementation, semiconductor chips in one semiconductor package, such as the semiconductor chips 2200 of FIG. 10 and the semiconductor chips 2200b of FIG. 11, may be electrically connected to one another by a connection structure including a TSV.

One or more embodiments may provide a semiconductor device including a non-volatile vertical memory device.

One or more embodiments may provide a semiconductor device having a reduced size and improved performance and reliability.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A semiconductor device, comprising:
a substrate including:
an active region including a central active region extending in a first direction, a first extended active region extending from a first edge of the central active region in a second direction perpendicular to the first direction, a second extended active region extending from a second edge of the central active region in the second direction, a third extended active region extending from a third edge of the central active region in the second direction, and a fourth extended active region extending from a fourth edge of the central active region in the second direction, and
a device isolation layer defining the active region; and
a first gate structure, a second gate structure, a third gate structure, and a fourth gate structure on the active region and spaced apart from one another,
wherein:
the central active region, the first extended active region, and the first gate structure constitute a first pass transistor, the central active region, the second extended active region, and the second gate structure constitute a second pass transistor, the central active region, the third extended active region, and the third gate structure constitute a third pass transistor, and the central active region, the fourth extended active region, and the fourth gate structure constitute a fourth pass transistor,
the first to fourth pass transistors share one drain region on the central active region, and
the active region has an H shape in a plan view.

2. The semiconductor device as claimed in claim 1, wherein each of the first to fourth gate structures independently has a rectangular shape or an L shape in a plan view.

3. The semiconductor device as claimed in claim 1 or 2, further comprising a drain contact on the drain region, wherein the drain contact is on a plane parallel to the first direction and the second direction and in an oblique direction with respect to the first to fourth gate structures.

4. The semiconductor device as claimed in claim 1, 2, or 3, wherein the first to fourth pass transistors each include high voltage pass transistors.

5. The semiconductor device as claimed in any one of claims 1 to 4, wherein the device isolation layer includes an extended device isolation layer extending into a part of the central active region in the first direction.

6. The semiconductor device as claimed in any one of claims 1 to 5, further comprising an isolation region in the substrate under the device isolation layer,
wherein the isolation region includes:
a first isolation region surrounding the active region, and
a first extended isolation region and a second extended isolation region extending from the first isolation region toward the central active region in the second direction and spaced apart from each other in the second direction.

7. The semiconductor device as claimed in claim 6, further comprising a first contact on the first extended active region, a second contact on the second extended active region, a third contact on the third extended active region, and a fourth contact on the fourth extended active region,
wherein:
the first extended isolation region is between the first contact and the second contact, and
the second extended isolation region is between the third contact and the fourth contact.

8. The semiconductor device as claimed in any one of claims 1 to 6, wherein the active region further includes:
a first protruding active region protruding in the first direction from the first extended active region,
a second protruding active region protruding in the first direction from the second extended active region,
a third protruding active region protruding in the first direction from the third extended active region, and
a fourth protruding active region protruding in the first direction from the fourth extended active region.

9. The semiconductor device as claimed in claim 8, wherein at least one of the first to fourth protruding active regions overlaps at least one of the first to fourth gate structures in the first direction.

10. The semiconductor device as claimed in claim 8 or 9, further comprising an isolation region in the substrate under the device isolation layer,
wherein the isolation region includes:
a first isolation region surrounding the active region,
a first extended isolation region and a second extended isolation region extending from the first isolation region toward the central active region in the second direction, and
the first extended isolation region and the second extended isolation region each have a T shape in a plan view.

11. A semiconductor device, comprising:
a peripheral circuit structure; and
a cell array structure overlapping the peripheral circuit structure in a vertical direction and including a first memory cell block, a second memory cell block, a third memory cell block, and a fourth memory cell block,
wherein:
the peripheral circuit structure is in accordance with device of any one of claims 1 to 10.

12. The semiconductor device as claimed in claim 11, wherein:
the cell array structure further includes a plurality of first bonding pads,
the peripheral circuit structure further includes a plurality of second bonding pads, and
the plurality of first bonding pads are bonded to the plurality of second bonding pads.

13. The semiconductor device as claimed in claim 11 or 12, wherein:
the cell array structure includes a cell stack structure and a cell substrate, and
the cell substrate is between the cell stack structure and the peripheral circuit structure.

14. The semiconductor device as claimed in claim 11, 12, or 13, wherein one of the first to fourth pass transistors is configured to transmit an operating voltage to one of the first to fourth memory cell blocks corresponding to the one of the first to fourth pass transistors based on a block selection signal.

15. An electronic system, comprising:
a main substrate;
a semiconductor device on the main substrate; and
a controller electrically connected to the semiconductor device on the main substrate,
wherein the semiconductor device is in accordance with any one of claims 1 to 14.
